Europäisches Patentamt

European Patent Office

Office européen des brevets

(11) Veröffentlichungsnummer : **0 194 962**
**B1**

# (12) EUROPÄISCHE PATENTSCHRIFT

(45) Veröffentlichungstag der Patentschrift :
30.11.88

(21) Anmeldenummer : 86730038.6

(22) Anmeldetag : 04.03.86

(51) Int. Cl.⁴ : **H 05 K   7/14**

(54) Elektronisches Gerät für Schalttafel- oder Pulteinbau mit einem mantelartigen Gehäuse.

(30) Priorität : 13.03.85 DE 3509405

(43) Veröffentlichungstag der Anmeldung :
17.09.86 Patentblatt 86/38

(45) Bekanntmachung des Hinweises auf die Patenterteilung : 30.11.88 Patentblatt 88/48

(84) Benannte Vertragsstaaten :
AT BE CH DE FR GB IT LI NL

(56) Entgegenhaltungen :
EP-A- 0 015 054
EP-A- 0 040 754
EP-A- 0 113 238
US-A- 4 251 853
IBM TECHNICAL DISCLOSURE BULLETIN, Band 26, Nr. 10B, März 1984, Seiten 5720-5722, New York, US; D.G. KASDAGLY et al.: "Modular processor - a method and apparatus for mass producing a computer system"

(73) Patentinhaber : Siemens Aktiengesellschaft Berlin und München
Wittelsbacherplatz 2
D-8000 München 2 (DE)

(72) Erfinder : Lesche, Wolfgang, Dipl.-Ing.
Wildbergweg 13
D-1000 Berlin 37 (DE)
Erfinder : Hampel, Ulf, Ing. grad.
Prühssstrasse 22
D-1000 Berlin 42 (DE)

**Beschreibung**

Die Erfindung bezieht sich auf ein elektronisches Gerät für Schalttafel- oder Pulteinbau mit einem mantelartigen Gehäuse, das an einer Stirnseite (Vorderseite) mit einer Anzeige- und Bedieneinheit abgeschlossen ist und das in seinem Innern ein Elektronikteil mit einem Mikroprozessor, eine in Längsrichtung des Gehäuses sich erstreckende Leiterplatte mit einer Stromversorgungseinrichtung und mindestens eine in Längsrichtung des Gehäuses einführbare weitere Leiterplatte mit einem Signalumformer enthält.

Bei einem bekannten Gerät dieser Art (« Instruction Manual for Monitroller I Single Loop Digital Controllers — AN25C Series », 2. Ausgabe Dez. 1983, Figur 6-2 der Firma Analogic Corporation) enthält ein mantelartiges Gehäuse stirnseitig eine Anzeige-Einheit, hinter der sich Leiterplatten befinden. Die Leiterplatten weisen u. a. eine Stromversorgungseinrichtung, einen Elektronikteil mit einem Mikrocomputer und einen Signalumformer auf. Die Leiterplatten sind vor der Anbringung der Anzeige-Einheit von vorn her in das mantelartige Gehäuse einschiebbar und so ausgebildet, daß sie am hinteren Teil des mantelartigen Gehäuses aus diesem hervorstehen ; dort an den Leiterplatten befindliche Anschlußelemente sind somit von außen zugänglich. Vor dem Einführen in das Gehäuse sind die Leiterplatten durch flexible Leiterbänder miteinander zu verbinden, weil nur eine mittlere Leiterplatte über Steckverbindungen mit der Anzeige-Einheit verbunden werden kann. Dieser Aufbau bringt es mit sich, daß bei dem bekannten Gerät beispielsweise bei einem Austausch der Leiterplatte mit dem Signalumformer die Anzeige-Einheit gelöst und anschließend sämtliche Leiterplatten aus dem Gehäuse nach vorn entnommen werden müssen.

Der Erfindung liegt die Aufgabe zugrunde, ein elektronisches Gerät für Schalttafel- oder Pulteinbau vorzuschlagen, bei dem sich zumindest die Leiterplatten mit Signalumformern ohne großen Aufwand aus dem Gehäuse entnehmen und wieder einsetzen lassen, so daß beispielsweise ein Austausch einer Leiterplatte mit einem Signalumformer gegen eine andere Leiterplatte mit einem anderen Signalumformer oder das Einbringen ergänzender Leiterplatten mit Signalumformern auch während des Betriebs des elektronischen Gerätes möglich ist.

Zur Lösung dieser Aufgabe ist bei einem elektronischen Gerät für Schalttafel- oder Pulteinbau der eingangs angegebenen Art erfindungsgemäß im Innern des mantelartigen Gehäuses hinter der Anzeige-und Bedieneinheit quer zur Längsachse des Gehäuses eine Verbindungsplatte an dem Gehäuse angebracht und an der Verbindungsplatte der Elektronikteil mit dem Mikroprozessor gehalten ; an der Verbindungsplatte sind Steckkontakteinrichtungen befestigt, mit denen jeweils eigene Gegensteckkontakteinrichtungen zumindest der weiteren Leiterplatten bei ihrem Einführen von der Rückseite des Gehäuses her in Eingriff bringbar sind, und auf der Verbindungsplatte sind Leiterbahnen zur Verbindung der Steckkontakteinrichtungen untereinander und mit dem Elektronikteil vorhanden.

Ein wesentlicher Vorteil des erfindungsgemäßen elektronischen Gerätes besteht darin, daß bei ihm infolge der Einführbarkeit zumindest der weiteren Leiterplatten mit Signalumformern von der Rückseite des Gehäuses her ein einfacher Austausch bzw. eine einfache Ergänzung vorgenommen werden kann, weil die übrigen Teile des elektronischen Gerätes bei dieser Maßnahme nicht abgeschaltet und auch nicht ausgebaut werden müssen.

Bei dem erfindungsgemäßen elektronischen Gerät für Schalttafel- oder Pulteinbau kann der Elektronikteil mit dem Mikroprozessor in unterschiedlicher Weise mit der Verbindungsplatte elektrisch und konstruktiv verbunden sein. Als vorteilhaft wird es angesehen, wenn die Verbindungsplatte dicht hinter der Anzeige-und Bedieneinheit liegt und auf ihr die Schaltungselemente des Elektronikteils mit dem Mikroprozessor unmittelbar angeordnet sind. Dieser Ausführung wird man immer dann den Vorzug geben, wenn der Elektronikteil aus verhältnismäßig wenigen elektrischen Bauelementen besteht, weil anderenfalls der von der Verbindungsplatte zum Bestücken zur Verfügung gestellte Raum nicht ausreichen würde. Auch die Zahl der weiteren Leiterplatten und damit die Zahl der Signalumformer darf wegen des begrenzten Platzes auf der Verbindungsplatte bei diesem Ausführungsbeispiel nicht allzu groß sein, so daß diese Ausführungsform vor allem bei verhältnismäßig einfach ausgeführten Geräten der erfindungsgemäßen Art in Betracht kommt.

Bei dieser Ausführungsform des erfindungsgemäßen Gerätes trägt die Verbindungsplatte auf ihrer von der Anzeige- und Bedieneinheit abgewandten Seite eine Steckkontaktanordnung , mit der eine Steckgegenkontaktanordnung der einen Leiterplatte bei ihrem Einführen von der Rückseite des Gehäuses her in Eingriff bringbar ist.

Bei einer anderen Ausführungsform des erfindungsgemäßen Gerätes ist die Verbindungsplatte vorteilhafterweise etwa auf der halben Länge des Gehäuses angeordnet, und der Elektronikteil mit dem Mikroprozessor befindet sich auf einer zusätzlichen Leiterplatte ; die zusätzliche Leiterplatte liegt auf der der Anzeige- und Bedieneinheit zugewandten Seite der Verbindungsplatte, und die weiteren Leiterplatten sind auf der anderen Seite der Verbindungsplatte angeordnet. Bei dieser Ausführungsform sind nicht nur Schwierigkeiten mit dem vorhandenen Platz auf der Verbindungsplatte des erfindungsgemäßen Gerätes trotz umfangreicher Ausstattung mit Signalumformern vermieden, sondern es ist zusätzlich in vorteilhafter Weise ein relativ großer Abstand zwischen der zusätzlichen Leiterplatte mit dem Elektronikteil und den weiteren Leiterplatten geschaffen. Dieser große räumliche Abstand verhindert nämlich, daß von außen mit den Eingangsgrößen auf die Signalumformer eingekoppelte Störgrößen Auswirkungen auf den Elektronikteil haben.

Bei der eben beschriebenen Ausführungsform des erfindungsgemäßen Gerätes trägt die Verbindungsplatte vorteilhafterweise auf ihrer der Anzeige- und Bedieneinheit zugewandten Seite eine Steckkontakteinheit, mit der eine Steckgegenkontakteinheit der zusätzlichen Leiterplatte bei ihrem Einführen von der Vorderseite des Gehäuses her in Eingriff bringbar ist. Damit läßt sich die zusätzliche Leiterplatte in einfacher Weise mit der Verbindungsplatte elektrisch verbinden ; daß dies bei abgenommener Anzeige- und Bedieneinheit erfolgen muß, ist nicht von Nachteil, da der Elektronikteil in der Regel nicht ausgetauscht zu werden braucht.

Als vorteilhaft hat es sich ferner herausgestellt, wenn die zusätzliche Leiterplatte einen Fortsatz aufweist, mit dem sie durch die Verbindungsplatte hindurch bis zur Rückseite des Gehäuses reicht. Eine derartige Ausführung der zusätzlichen Leiterplatte ist unter anderem dann vorteilhaft, wenn das erfindungsgemäße Gerät mit verhältnismäßig vielen Signalumformern ausgerüstet werden soll, da dann nämlich auf dem Fortsatz der zusätzlichen Leiterplatte ein weiterer Signalumformer angeordnet werden kann.

Es erscheint ferner vorteilhaft, wenn bei dem erfindungsgemäßen Gerät die Verbindungsplatte auf ihrer der Anzeige- und Bedieneinheit zugewandten Seite eine Steckkontaktanordnung trägt, mit der eine Steckgegenkontaktanordnung der einen Leiterplatte bei ihrem Einführen von der Vorderseite des Gehäuses her in Eingriff bringbar ist. Auch diese Ausführung trägt zur leichteren Montage des erfindungsgemäßen Gerätes bei.

Auch die eine Leiterplatte des erfindungsgemäßen Gerätes ist vorteilhafterweise mit einem Ansatz versehen, mit dem sie durch die Verbindungsplatte hindurch bis zur Rückseite des Gehäuses reicht. Auf diese Weise läßt sich über eine Steckeranordnung im Bereich der Rückseite des Gehäuses die Betriebsspannung in einfacher Weise an die eine Leiterplatte der Stromversorgungseinrichtung von außen her heranführen.

Insbesondere zur Erleichterung der Montage wird es als vorteilhaft angesehen, wenn bei dem erfindungsgemäßen Gerät das Gehäuse im Bereich der Befestigungsstelle der Verbindungsplatte quergeteilt ist.

Als vorteilhaft hat es sich ferner erwiesen, wenn die den elektrischen Eingangsteil des jeweiligen Signalumformers bildenden elektrischen Bauelemente in der Nähe der Rückseite des Gehäuses auf den weiteren Leiterplatten angeordnet sind, wodurch sich die sicherheitsrelevanten Luft- und Kriechstrecken auf einfache Art einhalten lassen. Es können dann auch mit den Eingangsgrößen in die Signalumformer eingebrachte Störgrößen mit großer Sicherheit nicht nachteilig auf den Elektronikteil mit dem Mikroprozessor einwirken. Von besonderem Vorteil ist dieser Aufbau bei einer Ausführungsform des erfindungsgemäßen Gerätes, bei der die Verbindungsplatte dicht hinter der Anzeige- und Bedieneinheit liegt, weil in diesem Falle die weiteren Leiterplatten mit den Signalumformern verhältnismäßig dicht zum Elektronikteil liegen.

Zur Erläuterung der Erfindung ist in

Figur 1 ein Längsschnitt durch ein Ausführungsbeispiel des erfindungsgemäßen elektronischen Gerätes für Schalttafel- oder Pulteinbau, in

Figur 2 eine Ansicht auf die Rückseite desselben Ausführungsbeispiels, in

Figur 3 ein Längsschnitt durch ein weiteres Ausführungsbeispiel des erfindungsgemäßen Gerätes und in

Figur 4 eine Rückansicht auf dieses Ausführungsbeispiel wiedergegeben.

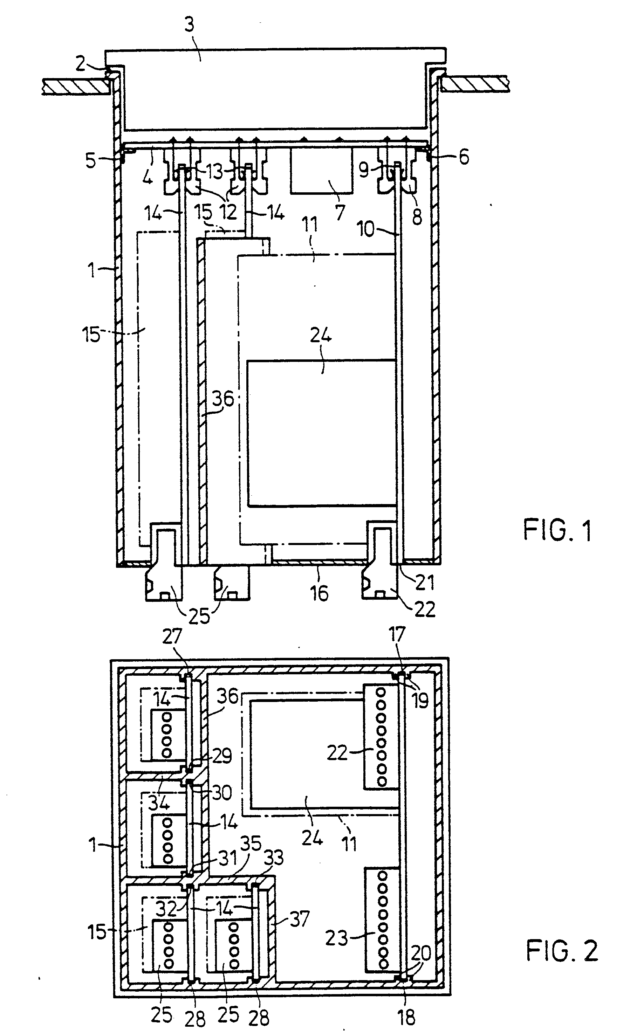

Das in den Figuren 1 und 2 dargestellte Ausführungsbeispiel des erfindungsgemäßen Regelgerätes weist ein mantelartiges Gehäuse 1 auf, das an seiner Vorderseite 2 mittels einer in Figur 1 nur in ihren äußeren Umrissen dargestellten Anzeige- und Bedieneinheit 3 verschlossen ist. Dicht hinter der Anzeige- und Bedieneinheit 3 ist eine Verbindungsplatte 4 angeordnet, und zwar so, daß sie quer zur Längsachse des Gehäuses 1 verläuft. Beispielsweise mittels Befestigungswinkeln 5 und 6 ist die Verbindungsplatte 4 mit dem Gehäuse 1 verbunden.

Unmittelbar an der Verbindungsplatte 4, die nach Art einer üblichen Leiterplatte ausgeführt ist, ist ein Mikroprozessor 7 eines Elektronikteils angebracht, der weitere in der Figur 1 nicht erkennbare Bauelemente, wie z. B. Speicherbausteine enthalten kann, die ebenfalls unmittelbar an der Verbindungsplatte 4 gehalten sind. Außerdem ist an der Verbindungsplatte 4 eine Steckkontaktanordnung 8 gehalten, in die eine Steckgegenkontaktanordnung 9 eingreift ; diese Gegenkontaktanordnung 9 kann von Leiterbahnen einer Leiterplatte 10 gebildet sein, auf der sich eine Stromversorgungseinrichtung 11 befindet.

Außerdem sind an der Verbindungsplatte 4 Kontakteinrichtungen 12 angebracht, in die Steckgegenkontakteinrichtungen 13 eingreifen. Diese Steckgegenkontakteinrichtungen 13, z. B. Leiterbahnenden, befinden sich auf weiteren Leiterplatten 14, die jeweils einen in seinen Umrissen strichpunktiert angedeuteten Signalumformer 15 tragen. Verbindungsleitungen von der Verbindungsplatte 4 zur Anzeige- und Bedieneinheit 3 sind in der Figur 1 nicht dargestellt.

Die eine Leiterplatte 10 mit der Stromversorgungseinrichtung 11 ist — wie Figur 1 deutlich zeigt — von der Rückseite 16 des Gehäuses 1 in dieses einführbar. Zur mechanischen Halterung dieser einen Leiterplatte 10 dienen Führungsnuten 17 und 18 an der inneren Wandung des Gehäuses 1 ; diese Führungsnuten 17 und 18 sind von Stegen 19 bzw. 20 gebildet (vgl. Fig. 2). An ihrem der Rückseite 16 des Gehäuses 1 benachbarten Ende 21 trägt die eine Leiterplatte 10 Verbindungseinrichtungen 22 und 23.

Über diese Verbindungseinrichtungen 22 und 23 können an die Stromversorgungseinrichtung 11, die u. a. einen Netztransformator 24 aufweisen kann, unterschiedlich hohe Betriebsspannungen angelegt werden.

Ebenso wie die eine Leiterplatte 10 so sind auch die weiteren Leiterplatten 14 an ihren der Rückseite 16 des Gehäuses 1 benachbarten Enden mit weiteren Verbindungseinrichtungen 25 versehen, über die (nicht gezeigte) Signalleitungen mit den Signalumformern verbunden werden können. Wie die Figur 2 zeigt, sind bei dem dargestellten Ausführungsbeispiel vier weitere Leiterplatten 14 mit Signalumformern vorhanden, von denen drei übereinander angeordnet sind, während eine weitere Leiterplatte im unteren Bereich neben einer ersten angeordnet ist. Die mechanische Halterung der weiteren Leiterplatten 14 erfolgt über Nuten 27 und 28 an der oberen und unteren Wandung des Gehäuses 1 sowie über weitere Nuten 29, 30 sowie 31, 32 und 33 in Zwischenwänden 34 und 35, die mittels Tragwänden 36 und 37 abgestützt sind.

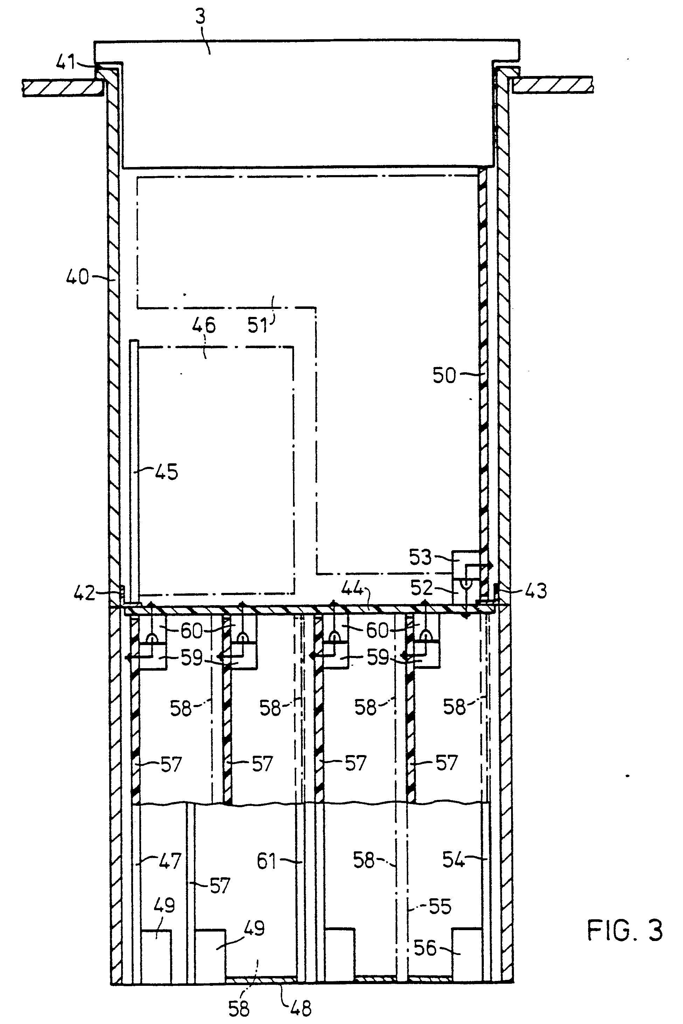

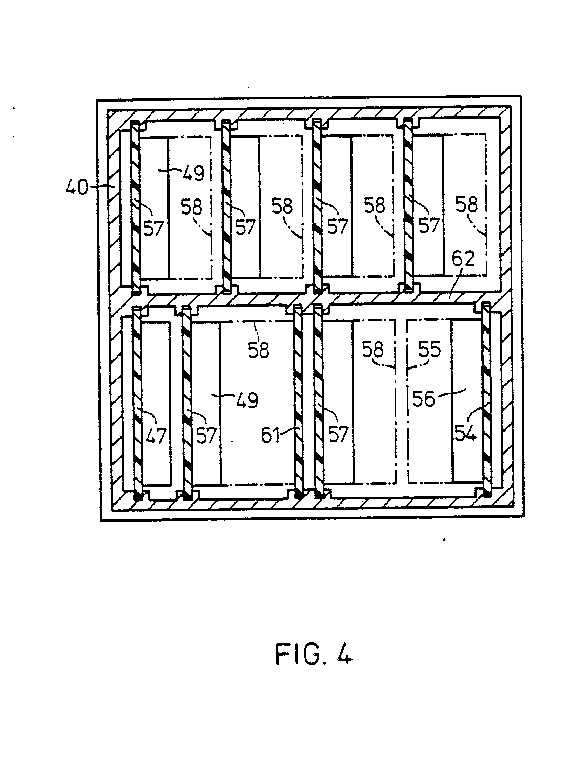

Bei dem Ausführungsbeispiel nach den Figuren 3 und 4 ist ein mantelartiges Gehäuse 40 an seiner Stirn- bzw. Vorderseite 41 wiederum durch eine Anzeige- und Bedieneinheit 3 abgeschlossen. Etwa auf halber Länge des Gehäuses 40 ist an diesem mittels Befestigungsteilen 42 und 43 eine Verbindungsplatte 44 angebracht. Das Gehäuse 40 ist im Bereich der Verbindungsplatte 44 quergeteilt, wobei die Verbindung der beiden Gehäuseteile fest oder lösbar ausgeführt sein kann.

Im Raum zwischen der Anzeige- und Bedieneinheit 3 und der Verbindungsplatte 44 ist eine Leiterplatte 45 mit einer Stromversorgungseinrichtung 46 untergebracht, die in dem dargestellten Ausführungsbeispiel wiederum nur schematisch angedeutet ist. Die eine Leiterplatte 45 weist einen Fortsatz 47 auf, mit dem sie sich — wie jeweils im unteren Teil der Figuren 3 und 4 erkennbar ist — bis zur Rückseite 48 des Gehäuses 40 erstreckt. Mittels einer Anschlußeinheit 49 können dann nicht dargestellte Stromversorgungsleitungen in einfacher Weise elektrisch mit der einen Leiterplatte 45 verbunden werden. Zur elektrischen Verbindung der einen Leiterplatte 45 mit der Verbindungsplatte 44 ist auf der Verbindungsplatte 44 eine Steckkontaktanordnung (in den Figuren 3 und 4 nicht erkennbar) angebracht, in die eine Steckgegenkontaktanordnung auf der einen Leiterplatte 45 einbringbar ist. Die eine Leiterplatte 45 wird nämlich bei abgenommener Anzeige- und Bedieneinheit von der Vorderseite 41 her in das Gehäuse 40 eingeschoben, wobei dann die Steckgegenkontaktanordnung mit der Steckkontaktanordnung zur Herstellung der Verbindung zwischen der einen Leiterplatte 45 und der Verbindungsplatte 44 in Eingriff kommt.

In dem Raum zwischen der Verbindungsplatte 44 und der Anzeige- und Bedieneinheit 3 befindet sich eine zusätzliche Leiterplatte 50, die einen in Figur 3 ebenfalls nur schematisch (strichpunktiert) dargestellten Elektronikteil 51 mit Mikroprozessor trägt. Die Verbindungsplatte 44 ist an ihrem der zusätzlichen Leiterplatte 50 benachbarten Bereich mit einer Steckkontakteinheit 52 versehen, die in eine an der zusätzlichen Leiterplatte 50 angebrachte Steckgegenkontakteinheit 53 eingreift. Dieser Eingriff kommt bei einem Einschieben der zusätzlichen Leiterplatte 50 bei abgenommener Anzeige- und Bedieneinheit 3 von der Vorderseite 41 des Gehäuses 40 her zustande. Die zusätzliche Leiterplatte 50 ist mit einem Ansatz 54 versehen, mit dem sie durch eine in den Figuren 3 und 4 nicht erkennbare Ausnehmung in der Verbindungsplatte 44 hindurchragt. Dabei erstreckt sich der Ansatz 54 bis zur Rückseite 48 des Gehäuses 40. Im Bereich dieses Ansatzes kann die zusätzliche Leiterplatte mit einem weiteren Signalumformer 55 versehen sein, an den über eine Verbindungseinrichtung 56 nicht gezeigte Signalleitungen anschließbar sind.

Auf der von der Anzeige- und Bedieneinheit 3 abgewandten Seite der Verbindungsplatte 44 befinden sich weitere Leiterplatten 57, auf denen nur schematisch dargestellte Signalumformer 58 aufgebracht sind. Jede weitere Leiterplatte 57 ist in der Nähe der Verbindungsplatte 44 mit einer Steckgegenkontakteinrichtung 59 ausgerüstet, die in entsprechende Steckkontakteinrichtungen 60 auf der Verbindungsplatte 44 eingreifen, wodurch die weiteren Leiterplatten 57 jeweils elektrisch mit der Verbindungsplatte 44 verbunden sind. Wie Figur 3 zeigt, können die einzelnen Signalumformer 58 unterschiedlich groß sein, beispielsweise neben einer weiteren Leiterplatte 57 noch eine ergänzende Leiterplatte 61 aufweisen, wodurch dann ein sandwichartiger Aufbau gebildet ist.

Figur 4 zeigt ergänzend, daß die weiteren Leiterplatten 57 in zwei Etagen innerhalb des Gehäuses 40 angeordnet sind. Das Gehäuse 40 ist deshalb in seinem rückseitigen Bereich mit einer Zwischenwand 62 versehen, die einerseits als Tragelement für die im oberen Teil untergebrachten weiteren Leiterplatten 57 und andererseits mit ihren Führungsnuten als Führungselement für die im unteren Teil angeordneten weiteren Leiterplatten 57 dient.

Die Verbindungsplatte kann bei beiden oben beschriebenen Ausführungsformen des erfindungsgemäßen Gerätes zur elektrischen Verbindung der einzelnen elektrischen Baugruppen untereinander einzelne Leiterbahnen oder busartig angeordnete Leiterbahnen aufweisen.

## Patentansprüche

1. Elektronisches Gerät für Schalttafel- oder Pulteinbau mit einem mantelartigen Gehäuse, das an einer Stirnseite mit einer Anzeige- und Bedieneinheit abgeschlossen ist und das in seinem Innern einen Elektronikteil mit einem Mikroprozessor, eine in Längsrichtung des Gehäuses sich erstrekende Leiterplatte mit einer Stromversorgungseinrichtung und mindestens eine in Längsrichtung des Gehäuses einführbare weitere Leiterplatte mit einem Signalumformer enthält, dadurch gekennzeichnet, daß im Innern des mantelartigen Gehäuses (1) hinter der Anzeige- und Bedieneinheit (3) quer zur Längsachse des Gehäuses (1) eine Verbindungsplatte (4) an dem Gehäuse (1) angebracht ist, daß an der Verbindungsplatte (4) der Elektronikteil (11) mit dem Mikroprozessor gehalten ist, daß an der Verbindungsplatte (4) Steckkontakteinrichtungen (12) befestigt sind, mit denen jeweils Steckgegenkontakteinrichtungen (13) zumindest der weiteren Leiterplatten (14) bei ihrem Einführen von der Rückseite (16) des Gehäuses (1) her in Eingriff bringbar sind und daß auf der Verbindungsplatte (4) Leiterbahnen zur Verbindung der Steckkontakteinrichtungen (12) untereinander und mit dem Elektronikteil (11) vorhanden sind.

2. Gerät nach Anspruch 1, dadurch gekennzeichnet, daß die Verbindungsplatte (4) dicht hinter der Anzeige- und Bedieneinheit (3) liegt und daß auf ihr die Schaltungselemente des Elektronikteils (11) mit dem Mikroprozessor unmittelbar angeordnet sind.

3. Gerät nach Anspruch 2, dadurch gekennzeichnet, daß die Verbindungsplatte (4) auf ihrer von der Anzeige- und Bedieneinheit (3) abgewandten Seite eine Steckkontaktanordnung (8) trägt, mit der eine Steckgegenkontaktanordnung (9) der einen Leiterplatte (10) bei ihrem Einführen von der Rückseite (16) des Gehäuses (1) her in Eingriff bringbar ist.

4. Gerät nach Anspruch 1, dadurch gekennzeichnet, daß die Verbindungsplatte (44) etwa auf der halben Länge des Gehäuses (40) angeordnet ist, daß sich der Elektronikteil (51) mit dem Mikroprozessor auf einer zusätzlichen Leiterplatte (50) befindet und daß die zusätzliche Leiterplatte (10) auf der der Anzeige- und Bedieneinheit (3) zugewandten Seite der Verbindungsplatte (44) liegt und die weiteren Leiterplatten (57) auf der anderen Seite der Verbindungsplatte (44) angeordnet sind.

5. Gerät nach Anspruch 4, dadurch gekennzeichnet, daß die Verbindungsplatte (44) auf ihrer der Anzeige- und Bedieneinheit (3) zugewandten Seite eine Steckkontakteinheit (53) trägt, mit der eine Steckgegenkontakteinheit (52) der zusätzlichen Leiterplatte (50) bei ihrem Einführen von der Vorderseite (41) des Gehäuses (40) her in Eingriff bringbar ist.

6. Gerät nach Anspruch 4 oder 5, dadurch gekennzeichnet, daß die zusätzliche Leiterplatte (50) einen Fortsatz (54) aufweist, mit dem sie durch die Verbindungsplatte (44) hindurch bis zur Rückseite (48) des Gehäuses (40) reicht.

7. Gerät nach einem der Ansprüche 4 bis 6, dadurch gekennzeichnet, daß die Verbindungsplatte (44) auf ihrer der Anzeige- und Bedieneinheit (3) zugewandten Seite eine Steckkontaktanordnung trägt, mit der eine Steckgegenkontaktanordnung der einen Leiterplatte (45) bei ihrem Einführen von der Vorderseite (16) des Gehäuses (40) her in Eingriff bringbar ist.

8. Gerät nach Anspruch 7, dadurch gekennzeichnet, daß die eine Leiterplatte (45) einen Ansatz (47) aufweist, mit dem sie durch die Verbindungsplatte (44) hindurch bis zur Rückseite

48) des Gehäuses (40) reicht.

9. Gerät nach einem der Ansprüche 4 bis 8, dadurch gekennzeichnet, daß das Gehäuse (40) im Bereich der Befestigungsstelle der Verbindungsplatte (44) quergeteilt ist.

10. Gerät nach einem der vorangehenden Ansprüche, dadurch gekennzeichnet, daß die den elektrischen Eingangsteil des jeweiligen Signalumformers (58) bildenden elektrischen Bauelemente in der Nähe der Rückseite (48) des Gehäuses (40) auf den weiteren Leiterplatten (57) angeordnet sind.

**Claims**

1. Electronic apparatus for control panel or desk fitting with a casing-like housing, which at a front end terminates with a display and operator unit and which contains in its interior an electronic part with a microprocessor, a printed-circuit board extending in the longitudinal direction of the housing with a power supply device and at least one further printed-circuit board with a signal converter, able to be introduced in the longitudinal direction of the housing, characterised in that, in the interior of the casing-like housing (1) behind the display and operator unit (3) transverse to the longitudinal axis of the housing (1) a connecting board (4) is attached to the housing (1), in that the electronic part (11) with the microprocessor is held on the connecting board (4), in that plug-in contact devices (12) are secured to the connecting board (4) with which in each case plug-in counter contact devices (13) at least of the further printed-circuit boards (14) are able to be brought into engagement when they are introduced from the rear side (16) of the housing (1) and in that on the connecting board (4) printed conductors for connecting the plug-in contact devices (12) are provided under each other and with the electronic part (11).

2. Apparatus according to claim 1, characterised in that the connecting board (4) lies close behind the display and operator unit (3) and in that the circuit elements of the electronic part (11) with the microprocessor are directly arranged on it.

3. Apparatus according to claim 2, characterised in that the connecting board (4) carries on its side facing away from the display and operator unit (3) a plug-in contact arrangement (8), with which a plug-in counter contact arrangement (9) of the one printed-circuit board (10) is able to be brought into engagement when it is introduced from the rear side (16) of the housing (1).

4. Apparatus according to claim 1, characterised in that the connecting board (44) is arranged approximately along half the length of the housing (40), in that the electronic part (51) with the microprocessor is located on an additional printed-circuit board (50) and in that the additional printed-circuit board (10) lies on the side of the connecting board (44) facing the display and operator unit (3) and the further printed-circuit boards (57) are arranged on the other side of the connecting board (44).

5. Apparatus according to claim 4, characterised in that the connecting board (44) carries on its side facing the display and operator unit (3) a plug-in contact unit (53), with which a plug-in counter contact unit (52) of the additional conducting board (50) is able to be brought into engagement when it is introduced from the front side (41) of the housing (40).

6. Apparatus according to claim 4 or 5, characterised in that the additional printed-circuit board (50) has an extension (54) with which it reaches through the connecting board (44) to the rear side (48) of the housing (40).

7. Apparatus according to one of claims 4 to 6, characterised in that the connecting board (44) carries on its side facing the display and operator unit (3) a plug contact arrangement with which a plug counter contact arrangement of the one printed-circuit board (45) is able to be brought into engagement when it is introduced from the front side (16) of the housing (40).

8. Apparatus according to claim 7, characterised in that the one printed-circuit board (45) has an attachment (47) with which it reaches through the connecting board (44) to the rear side (48) of the housing (40).

9. Apparatus according to one of claims 4 to 8, characterised in that the housing (40) is divided in a transverse manner in the region of the securing point of the connecting board (44).

10. Apparatus according to one of the previous claims, characterised in that the electrical components forming the electrical input part of each signal converter (58) are arranged in the vicinity of the rear side (48) of the housing (40) on the further printed-circuit boards (57).

**Revendications**

1. Appareil électronique destiné à être monté dans un panneau de commande ou un pupitre et comportant un boîtier enveloppant, et qui se termine, au niveau d'une face frontale, par une unité d'affichage et de commande, et contient, en son intérieur, une partie électronique munie d'un microprocesseur, une plaquette à circuits imprimés s'étendant dans la direction longitudinale du boîtier et comportant un dispositif d'alimentation en courant, et au moins une autre plaquette à circuits imprimés pouvant être introduite dans la direction longitudinale du boîtier et comportant un transformateur de signaux, caractérisé par le fait qu'une plaquette de liaison (4) est montée à l'intérieur du boîtier enveloppant (1) et sur ce boîtier et derrière l'unité d'affichage et de commande (3), transversalement par rapport à l'axe longitudinal du boîtier (1), que la partie électronique (11) munie du microprocesseur est fixée à la plaquette de liaison (4), qu'à la plaquette de liaison (4) se trouvent fixés des dispositifs de contact à enfichage (12), avec lesquels des dispositifs respectifs (13) de contact à enfichage antagonistes au moins des autres plaquettes à circuits imprimés (14) peuvent être amenés en prise, lors de leur insertion à partir de la face arrière (16) du boîtier (1), et que des voies conductrices servant à relier les dispositifs de contact à enfichage (12) entre eux et à la partie électronique (11) sont prévues sur la plaquette de liaison (4).

2. Appareil suivant la revendication 1, caractérisé par le fait que la plaquette de liaison (4) est placée à proximité immédiate derrière l'unité d'affichage et de commande (3) et que les éléments des circuits de la partie électronique (11) équipée du microprocesseur sont disposés directement sur cette unité.

3. Appareil suivant la revendication 2, caractérisé par le fait que la plaquette de liaison (4) porte, sur sa face tournée à l'opposé de l'unité d'affichage et de commande (3), un dispositif de contact à enfichage (8), avec lequel un dispositif de contact antagoniste à enfichage (9) de la première plaquette à circuits imprimés (10) peut être amené en prise, lors de son insertion à partir de la face arrière (16) du boîtier (1).

4. Appareil suivant la revendication 1, caractérisé par le fait que la plaquette de liaison (44) est disposée approximativement à mi-distance sur la longueur du boîtier (40), que la partie électronique (51) munie du microprocesseur est située sur une plaquette à circuits imprimés supplémentaire (50) et que la plaquette à circuits imprimés supplémentaire (10) est située sur la face de la plaquette de liaison (44), tournée vers l'unité d'affichage et de commande (3), et que les autres plaquettes à circuits imprimés (57) sont disposées sur l'autre face de la plaquette de liaison (44).

5. Appareil suivant la revendication 4, caractérisé par le fait que la plaquette de liaison (44) porte, sur sa face tournée vers l'unité d'affichage et de commande (3), une unité de contact à enfichage (53), avec laquelle l'unité de contact à enfichage antagoniste (52) de la plaquette à circuits imprimés supplémentaire (50) peut être amenée en prise lors de son insertion à partir de la face avant (41) du boîtier (40).

6. Appareil suivant la revendication 4 ou 5, caractérisé par le fait que la plaquette à circuits imprimés supplémentaire (50) possède un prolongement (54), par lequel elle s'étend, à travers la plaquette de liaison (44), jusqu'à la face arrière (48) du boîtier (40).

7. Appareil suivant l'une des revendications 4 à 6, caractérisé par le fait que la plaquette de liaison (44) porte, sur sa face tournée vers l'unité d'affichage et de commande (3), un dispositif de contact à enfichage, avec lequel un dispositif de contact à enfichage antagoniste de la première plaquette à circuits imprimés (45) vient en prise lors de son insertion à partir de la face avant (16) du boîtier (40).

8. Appareil suivant la revendication 7, caractérisé par le fait que la première plaquette à circuits imprimés (45) possède un appendice saillant (47) au moyen duquel elle s'étend, à travers la plaquette de liaison (44), jusqu'à la face arrière (48) du boîtier (40).

9. Appareil suivant l'une des revendications 4 à 8, caractérisé par le fait que le boîtier (40) est subdivisé transversalement au niveau de la zone de fixation de la plaquette de liaison (44).

10. Appareil suivant l'une des revendications précédentes, caractérisé par le fait que les composants électriques constituant la partie d'entrée électrique du convertisseur respectif de signaux (58), sont disposés à proximité de la face arrière (48) du boîtier (40), sur les autres plaquettes à circuits imprimés (57).

FIG. 1

FIG. 2

FIG. 3

FIG. 4